Europäisches Patentamt

(19) European Patent Office

Office européen des brevets

(11) Publication number: **0 172 350**
**B1**

(12) **EUROPEAN PATENT SPECIFICATION**

(45) Date of publication of patent specification: **25.10.89**

(51) Int. Cl.⁴: **H 03 K 19/094**

(21) Application number: **85107427.8**

(22) Date of filing: **14.06.85**

(54) **Complementary bi-mis gate circuit.**

(30) Priority: **25.06.84 JP 130438/84**
**21.09.84 JP 198811/84**

(43) Date of publication of application:
**26.02.86 Bulletin 86/09**

(45) Publication of the grant of the patent:
**25.10.89 Bulletin 89/43**

(84) Designated Contracting States:
**DE FR GB**

(56) References cited:
**US-A-3 631 528**
**US-A-4 103 188**

**PATENT ABSTRACTS OF JAPAN, vol. 4, no. 79**
**(E-14)561r, 7th June 1980, page 9 E 14; & JP - A**
**- 55 45207 (OKI DENKI KOGYO K.K.) 29-03-1980**

**PATENT ABSTRACTS OF JAPAN, vol. 8, no. 103**
**(E-244)1540r, 15th May 1984; & JP - A - 59**
**19435 (HITACHI SEISAKUSHO K.K.) 31-01-1984**

(73) Proprietor: **FUJITSU LIMITED**
**1015, Kamikodanaka Nakahara-ku**
**Kawasaki-shi Kanagawa 211 (JP)**

(72) Inventor: **Tanizawa, Tetsu**
**7-1-301, Hosoyama 1-chome Asao-ku**
**Kawasaki-shi Kanagawa, 215 (JP)**

(74) Representative: **Schmidt-Evers, Jürgen, Dipl.-**
**Ing. et al**
**Patentanwälte Dipl.-Ing. H. Mitscherlich Dipl.-**
**Ing. K. Gunschmann Dipl.-Ing. Dr.rer.nat. W.**
**Körber Dipl.-Ing. J. Schmidt-Evers Dipl.-Ing. W.**
**Melzer Steinsdorfstrasse 10**
**D-8000 München 22 (DE)**

(56) References cited:

**PATENT ABSTRACTS OF JAPAN, vol. 3, no. 54**
**(E-109), 10th May 1979, page 28 E 109; & JP - A**
**- 54 32259 (TOKYO SHIBAURA DENKI K.K.)**
**03-09-1979**

**PATENT ABSTRACTS OF JAPAN, vol. 2, no.**
**120, 6th October 1978, page 6968 E 78; & JP - A**
**- 53 86151 (NIPPON DENKI K.K.) 29-07-1978**

## Description

### Background of the invention

The present invention relates to a complementary Bi-MIS (metal insulator semiconductor device combined with bipolar semiconductor device) gate circuit which consists of CMIS (complementary metal insulator semiconductor) circuits and a load driving invertor) the CMIS circuit is composed of a PMIS (P type MIS) transistor and an NMIS (N type MIS) transistor and the load driving invertor is composed of a pull-up transistor and a pull-down transistor those of which are connected in series.

Each CMIS circuit is controlled so that a rush current (a first rush current) which flows through the CMIS circuit is reduced, and the load driving invertor is controlled so that a rush current (a second rush current) which flows through the driving invertor is removed. The first and second rush currents have flown from a high potential source to a low one because respective transistors in the CMIS circuit and the driving invertor are simultaneously ON in a transient time during which an input signal of the gate circuit changes its level from low to high or from high to low.

Furthermore, the complementary Bi-MIS gate circuit is controlled so that an non-effective current which flows in the gate circuit is removed. The non-effective current has flown when the gate circuit is applied as a 3-state circuit which is operating in a high impedance state.

The CMIS circuit comes to be widely used as a logic semiconductor integrated circuit because the CMIS circuit has almost zero power consumption in a steady state, a wide supply voltage range, and a high input impedance and a low output impedance which allows to have a large fan-out. A MOS (metal oxide semiconductor) transistor such as a PMOS (P type MOS) transistor or an NMOS (N type MOS) is a typical MIS transistor, so a CMOS circuit and a Bi-MOS gate circuit will be discussed hereinafter.

The MOS transistor is a surface conductive type device having lateral structure, so the MOS transistor is hard to drive much current comparing with a vertically structured semicondcutor device like a bipolar transistor. Therefore, the complementary Bi-MOS gate circuit is usually composed of the CMOS circuits and a load driving invertor consisting of a pull-up bipolar transistor and a pull-down bipolar transistor those of which are connected in series forming a Totem pole type circuit for example. Consequently, the high input impedance characteristic of the CMOS circuit and the low output impedance characteristic of the bipolar transistor have been effectively utilized in the complementary Bi-MIS (Bi-MOS) gate circuit.

However, a complementary Bi-MOS gate circuit of this type has a problem that first and second rush currents flow in the gate circuit in a transient time during the transistors in the CMOS circuit and the load driving invertor are simultaneously ON. The rush currents produce noise which affects to other circuits through a power source line, and increase the power dissipation and rise temperature of the complementary Bi-MOS gate circuit.

Patent Abstracts of Japan, vol. 4, No. 79 (E-14) [561], 7th ·June 1980, page 9E14 discloses a Bi-MOS gate circuit in which spike noise during logic state transition is avoided by inserting two level-shift diodes between the drains of a single CMOS driving stage. In this circuit, the base of the NPN transistor of the output stage is connected to the drain of the p-channel MOS transistor, and the base of the PNP-transistor is connected to the drain of the n-channel MOS transistor.

### Summary of the invention

A first object of the present invention is to suppress the rush currents in a complementary Bi-MOS gate circuit; the first rush current produced in the CMOS circuit is reduced and the second rush current produced in the load driving invertor is removed.

A second object which is achieved by a further embodiment of the invention is to reduce an non-effective current, which flows in the complementary Bi-MOS gate circuit when the gate circuit is applied to a 3-state circuit which is operating in a high impedance state, as little as zero.

The first object can be achieved by applying two CMOS circuits each having an impedance element between a PMOS transistor and an NMOS transistor which compose the CMOS circuit. The connection between the CMOS circuits and the load driving invertor is made so that a high level end of the impedance element in one CMOS circuit is connected to the base terminal of the pull-up bipolar transistor in the load driving invertor and a low level end of the impedance element in the other CMOS circuit is connected to the base terminal of the pull-down bipolar transistor in the invertor.

Inserting the impedance element into respective CMOS circuit, when the level of an input signal fed to the complementary Bi-MOS gate circuit changes from low to high or high to low, the first rush currents which occur in respective ·CMOS circuits can be reduced and the second rush current which occurs in the load driving invertor can be removed because the base voltage of the pull-up and pull-down bipolar transistors are controlled by the impedance elements so that both bipolar transistors are cut off.

The second object can be achieved by adding PMOS and NMOS transistors and an invertor to the base circuits of the PNP and NPN transistors in the load driving invertor. These adding elements are controlled by enable signal applied to the complementary Bi-MOS gate circuit so as to reduce a current which flows through the complementary Bi-MOS gate circuit to almost zero when the gate circuit is applied to a 3-state circuit which is operating in a high impedance state.

Applying the present invention, the rush currents and the non-effective current can be reduced, so the noise, the temperature rise, and the power dissipation of the prior art complementary Bi-MOS gate circuit can be reduced by a simple improvement of the gate circuit.

Brief description of the drawings

Fig. 1 is a complementary Bi-MOS gate circuit embodying the present invention;

Fig. 2(a) is the $V_{DS}-I_{DS}$ characteristics of a PMOS transistor and an NMOS transistor used in a prior art CMOS circuit;

Fig. 2(b) is an input-output signal voltage transfer characteristic and a first rush current of the prior art CMOS circuit;

Fig. 2(c) is the prior art CMOS circuit;

Fig. 3(a) is the $V_{DS}-I_{DS}$ characteristics of a PMOS transistor and an NMOS transistor, including a voltage drop characteristic of a resistor R in a CMOS circuit;

Fig. 3(b) is an input-output signal voltage transfer characteristic and a first rush current of the CMOS circuit having the resistor R;

Fig. 3(c) is the CMOS circuit having the resistor 5, the CMOS circuit being a part of the complementary Bi-MOS circuit embodying the preset invention;

Fig. 4 is the transfer characteristics of the potential at a point B, and a point C to an input signal voltage of the invented complementary Bi-MOS gate circuit;

Fig. 5 is a complementary Bi-MOS circuit embodying the present invention, the gate circuit being applied as a 3-state circuit; and

Fig. 6 is another complementary Bi-MOS gate circuit embodying the present invention, the gate circuit being applied as the 3-state circuit.

Detailed description of the invention

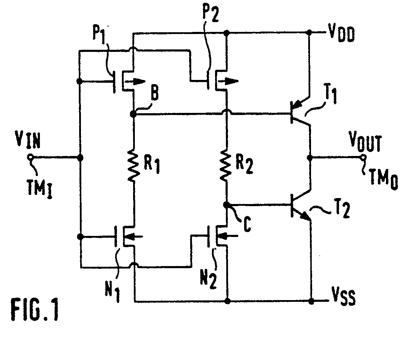

The present invention will become clear from reading the detailed description of an embodiment with reference to the drawings of Figs. 1—6.

Fig. 1 shows a complementary Bi-MOS gate circuit embodying the present invention. The complementary Bi-MOS gate circuit is composed of two CMOS circuits (a first CMOS circuit and a second CMOS circuit) and a load driving invertor. The first CMOS circuit comprises a first PMOS transistor $P_1$, a first NMOS transistor $N_1$, and a first resistor $R_1$, and the second CMOS circuit comprises a second PMOS transistor $P_2$, a second NMOS transistor $N_2$, and a second resistor $R_2$, the resistors $R_1$ and $R_2$ are used as the impedance element. The load driving invertor comprises a P type junction transistor (PNP transistor) $T_1$ and an N type junction transistor (NPN transistor) $T_2$. There are many kinds of junction transistors each having longitudinal structure such as a bipolar transistor (BPT) or a unipolar transistor which is well known as a punching through devide like a static induction transistor (SIT) or a permeable base transistor (PDT). The BPT will be taken for discussion hereinafter.

Resistors $R_1$ and $R_2$ are connected between the drains of $P_1$, $N_1$ and $P_2$, $N_2$ of the first and second CMOS circuits respectively, and a high level end (a point B in Fig. 1) of $R_1$ and a low level end (a point C in Fig. 1) of $R_2$ are connected to the bases of $T_1$ and $T_2$ respectively. The gate terminals of respective MOS transistors of the first and second CMOS circuits are connected to an input terminal $TM_1$ of the complementary Bi-MOS gate circuit, and the collectors of $T_1$ and $T_2$ are connected to an output terminal $TM_0$ of the gate circuit.

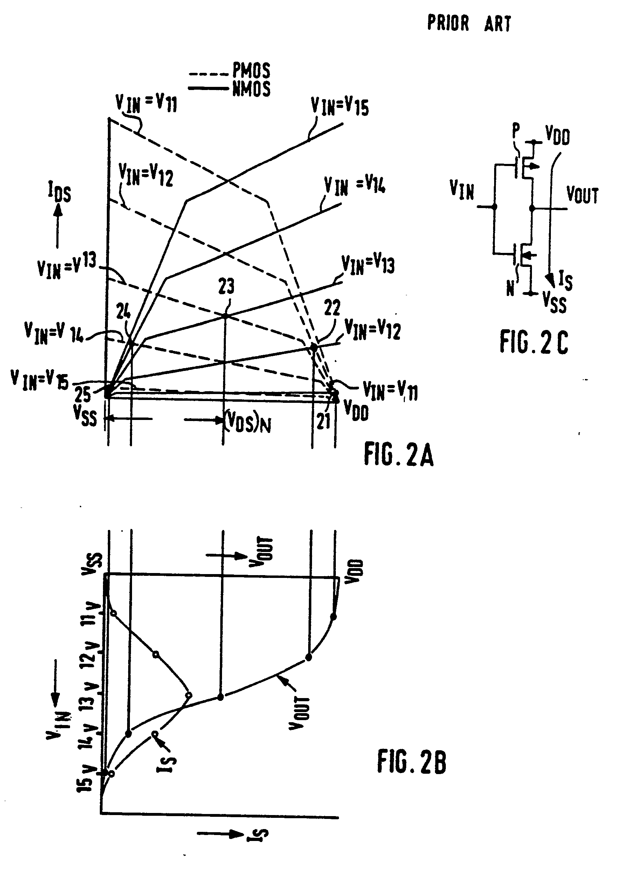

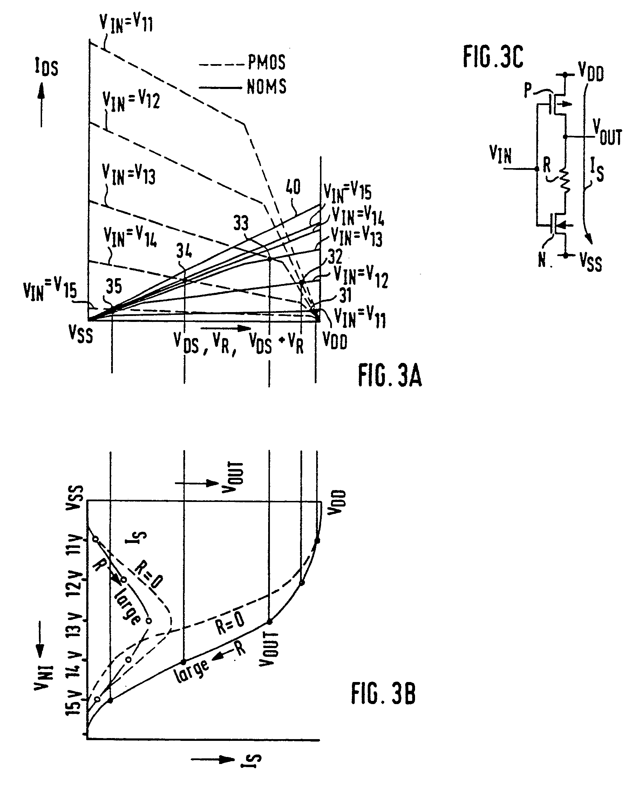

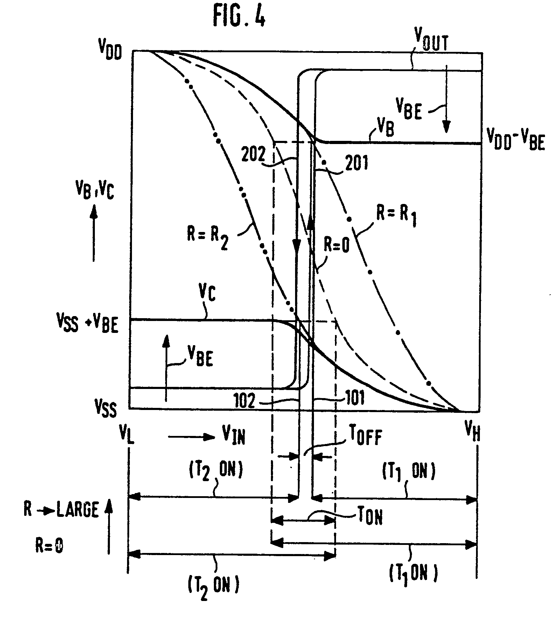

The operation of the complementary Bi-MOS gate circuit (Fig. 1) embodying the present invention will be disclosed in three steps discussing: (1) the $V_{DS}-I_{DS}$ characteristics ($V_{DS}$ is drain source voltage and $I_{DS}$ is a drain source current of a PMOS or an NMOS transistor) of a PMOS and an NMOS transistor both construct a conventional CMOS circuit, and an input-output voltage transfer characteristic of the conventional CMOS circuit, showing Fig. 2; (2) a $V_{DS}-I_{DS}$ characteristic and the input-output voltage transfer characteristic of a CMOS circuit having a resistor between the drain terminals of a PMOS and an NMOS transistor both compose the CMOS circuit, showing Fig. 3; and (3) the transient characteristics of $V_B$ and $V_C$ ($V_B$ is the potential at the point B, and $V_C$ is the potential at the point C) to an input signal voltage $V_{IN}$ of the complementary Bi-MOS gate circuit, showing Fig. 4.

Fig. 2(a) shows the $V_{DS}-I_{DS}$ characteristics of an NMOS transistor N and a PMOS transistor P in the conventional CMOS circuit shown in Fig 2(c). In Fig. 2(a), solid and dotted curves are for N and P respectively, and the curves are given by the parameter of the input signal voltage $V_{IN}$ applied ho the CMOS circuit; reference symbols $V_{11}...V_{15}$ show $V_{IN}$ from low to high.

Fig. 2(b) shows an input-output signal voltage ($V_{IN}-V_{OUT}$) transfer characteristic of the conventional CMOS circuit and a first rush current $I_S$ which flows from high source voltage $V_{DD}$ to low source voltage $V_{SS}$ through P and N when $V_{IN}$ is in the intermediate level between low and high. The $V_{IN}-V_{OUT}$ curve can be plotted by connecting the cross points of the $I_{DS}$ curves of P and N as shown in Fig. 2a, both having the same parameter $V_{IN}$ respectively; the points 21 to 25 are the cross points in Fig. 2a. The $I_S$ curve can be plotted by connecting the respective $I_{DS}$ values of the points 21 to 25.

As further shown in Fig. 2a, 2b and 2c $V_{OUT}$ is provided by N and P which divide the potential difference between $V_{DD}$ and $V_{SS}$.

$$V_{DD}-(V_{DS})_P=V_{OUT}=(V_{DS})_N+V_{SS}$$

wherein $(V_{DS})_{P;N}$ is $V_{DS}$ of P and N respectively.

According to Fig. 2b $(V_{DS})_N$ is high and is greater than $(V_{DS})_P$ when the level of $V_{IN}$ is low. $(V_{DS})_N$ decreases with the increase of the level of $V_{IN}$. Finally $(V_{DS})_P$ exceeds $(V_{DS})_N$ when the level of $V_{IN}$ is changed to high.

$I_{DS}$ of N always equals $I_{DS}$ of P, that is $(I_{DS})_N=(I_{DS})_P$, as N and P are connected in series. During the above transition time, $V_{OUT}$ changes its level from high to low and $I_S$ changes giving its maximum amount. On the contrary, when the $V_{IN}$

level changes from high to low, $V_{OUT}$ changes its level from low to high along the similar $V_{IN}-V_{OUT}$.

In the present invention, an impedance element is inserted between a PMOS transistor P and an NMOS transistor N. Fig. 3(c) shows a part of the invented circuit for discussing the effect of inserting the impedance element. A resistor R is used as the impedance element and is inserted between the drain terminals of P and N in a CMOS circuit and $V_{OUT}$ is taken from the high level end of R. In Fig. 3(a), dotted curves show the $V_{DS}-I_{DS}$ characteristic of P and solid curves show that of N including the voltage drop produced by R and $I_{DS}$ which flows through R and N. Fig. 3(b) shows a $V_{IN}-V_{OUT}$ transfer characteristic and a first rush current $I_S$ which flows in the CMOS circuit.

In Figs. 3(a) and (b), the reference numerals and symbols being equal to those in Figs. 2(a) and (b) designate the same subjects to the figures, a reference symbol $V_R$ shown in Figs. 3(a) and (c) shows the voltage drop of R, a solid line 40 in Fig. 3(a) shows the characteristic of the voltage drop. The axis of abscissa gives $V_R$, $V_{DS}$ for the $V_{DS}-I_{DS}$ curves of P, and $V_{DS}+V_R$ for the $V_{DS}-I_{DS}$ curves of N including $V_R$; the $V_{DS}$ and $V_R$ have the same scale each other on the axis. As shown in Fig. 3(a), the solid curves are shifted toward $V_{DD}$ comparing with the $V_{DS}-I_{DS}$ curves in Fig. 2(a), because, when $I_{DS}$ of N flows through R, actual $V_{DS}$ applied to N is what obtained by subtracting $V_R$ from the voltage $(V_{DS}+V_R)$ which is applied to R and N ($V_R$ can be obtained from the line 40), so the solid curves are shifted toward $V_{DD}$. Therefore, as shown in Fig. 3(b), $V_{OUT}$ is shifted so that its level is always higher than the $V_{OUT}$ level produced by the prior art CMOS circuit shown in Fig. 2 during a transient time in which $V_{IN}$ is changing its level from low to high or from high to low. The shift amount of $V_{OUT}$ depends on the resistance of R; a dotted curve (R=0) in Fig. 3(c) shows $V_{OUT}$ of the prior art CMOS circuit. The first rush current $I_S$ which flows through R and N during the transient time can be obtained from Fig. 3(a) as shown in Fig. 3(b). The $I_S$ curve has a maximum amount in the transient time and is shifted so as to be decreased with the increase of the resistance of R.

On the contrary, if $V_{OUT}$ is taken from the level end of R in the transient time, a $V_{OUT}$ curve is shifted toward $V_{SS}$ from the $V_{OUT}$ curve (R=0) produced by the prior art CMOS circuit and $I_S$ is also shifted so as to be decreased similarly to the $I_S$ curve in Fig. 3(b).

Fig. 4 shows a voltage transfer characteristic of the invented circuit shown in Fig. 1. The potential $V_B$ at a point B of a high level end of $R_1$ is provided by composing a transfer characteristic of $V_{OUT}$ such as shown in Fig. 3(b) and an input clamping characteristic of the PNP transistor $T_1$. As shown by $V_B$ curve (thick solid curve) in Fig. 4, when $V_{IN}$ increases from its low level $V_L$ to a high level $V_H$, $V_B$ tends to change along a one-dot chained curve (R=$R_1$) which is a curve when there were only a CMOS circuit of $P_1$, $N_1$ and $R_1$ as shown in Fig. 3(c), however actual $V_B$ in the invented circuit cannot fall below the base-emitter voltage $V_{BE}$ of

$T_1$ because $V_B$ is clamped by a level of $(V_{DD}-V_{BE})$. The potential $V_C$ at a point C of a low level end of $R_2$ in Fig. 1 is provided by also composing a transfer characteristic of $V_{OUT}$ and an input clamping characteristic of the NPN transistor $T_2$. As shown by $V_C$ curve (thick solid curve) in Fig. 4, when $V_{IN}$ increases from $V_L$ to $V_H$, $V_C$ tends to change along a two-dot chained curve (R=$R_2$) which is a curve when there were only a CMOS circuit of $P_2$, $N_2$, and $R_2$, however actual $V_C$ in the invented circuit cannot rise above the base-emitter voltage $V_{BE}$ of $T_2$ because $V_C$ is clamped by a level of $(V_{SS}+V_{BE})$.

On the $V_B$ and $V_C$ curves in Fig. 4, the region clamped to $V_{BE}$ from $V_{DD}$ and that clamped to $V_{BE}$ from $V_{SS}$ are ON regions of $T_1$ and $T_2$ respectively, and a threshold point, where $T_1$ is switched to ON from OFF, is shifted toward $V_H$ on the $V_{IN}$ axis with the increase of $R_1$ and the threshold point of $T_2$ is shifted toward $V_L$ with the increase of $R_2$.

Fig. 4 shows also a potential transfer curve of the prior art gate circuit for the comparison to the present invention. If the gate circuit only consists of one CMOS circuit and a load driving invertor and if there is no resistor in the CMOS circuit, the transfer curve becomes like a dotted line (R=0) and the ON regions of $T_1$ and $T_2$ are overlapped in an overlapped region $T_{ON}$ as shown at the bottom of Fig. 4 (an overlapped region is shown by two dotted vertical lines in the figure).

In the present invention, as the CMOS circuit has the resistors $R_1$ and $R_2$, $V_B$ and $V_C$ have the transfer characteristics as shown by solid lines in Fig. 4. Therefore, an OFF region in which $T_1$ and $T_2$ are simultaneously OFF can be provided. Two vertical solid lines 101 and 102 shows the cut-off lines of $T_1$ and $T_2$ respectively and shows also an OFF region of $T_1$ and $T_2$, a symbol $T_{OFF}$ indicates an OFF region; the ($T_2$ ON) region and the ($T_1$ ON) region come to be separated with the increase of $R_1$ and $R_2$. Thus, in the present invention, the second rush current can be removed by inserting the impedance element $R_1$ and $R_2$.

A proper amount of resistance is applied to $R_1$ and $R_2$ respectively to remove the second rush current, however the amount cannot be made so large because the amount designates the base currents of $T_1$ and $T_2$ respectively to operate them regularly.

An output signal voltage $V_{OUT}$ produced by the invented gate circuit is shown in Fig. 4. When $V_{IN}$ is in low level, $V_{OUT}$ is low because $T_2$ is ON and $T_1$ is OFF. The state of $T_2$ being ON is provided by $I_{DS}$ which flows through $P_2$, $R_2$, and the base-emitter of $T_2$, and the state of $T_1$ being OFF is provided by a fact that $N_1$ is off though $P_1$ is ON which keeps $V_B$ so high as to cut off $T_1$. This state is kept though $V_{IN}$ increases, however when $V_{IN}$ further increases, $V_C$ decreases along the two-dot curve (R=$R_2$) and so $T_2$ is brought to be cut off and $V_B$ decreases along the one-dot curve (R=$R_1$) and so $T_1$ is brought to be ON. This switching is done as shown by a transient part 201 which rises up along the line 101. Similarly, when $V_{IN}$ is in a high level and decreases to a low level, $V_{OUT}$ fall down from a high level to a low level along a transient part 202 along the line 102.

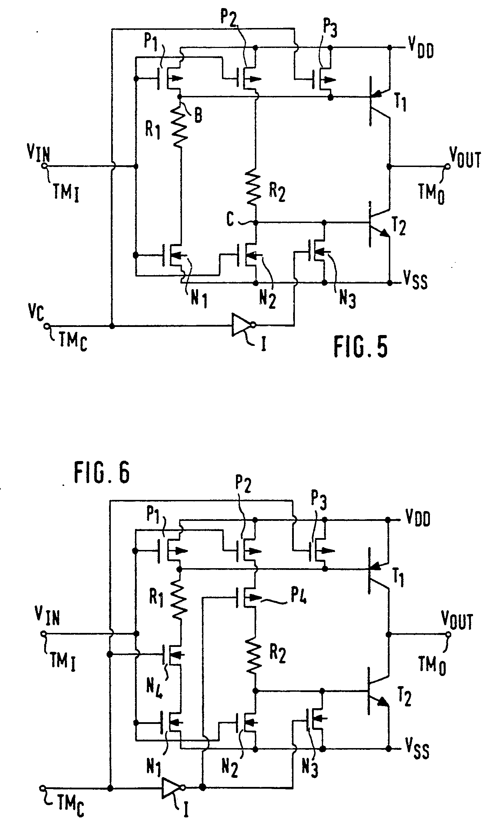

The complementary Bi-MOS gate circuit of the present invention can be applied as a 3-state circuit for suppressing a non-effective current which flows in the 3-state circuit of the prior art when the circuit operates in a high impedance state. The application can be made by adding PMOS and NMOS transistors and an invertor to the complementary Bi-MOS gate circuit embodying the present invention, as shown in Figs. 5 and 6.

In Fig. 5, the parts having the same symbols and numerals to those in Fig. 1 designate the same parts of the figure, a PMOS transistor $P_3$ is set between the base of $T_1$ and $V_{DD}$, an NMOS transistor $N_3$ is set between the base of $T_2$ and $V_{SS}$, the gate terminal of $P_3$ is connected to a control signal terminal $TM_C$ to which an enable control signal $V_C$ is applied and an inverted signal of $V_C$ is applied to the gate terminal of $N_3$ through an invertor 1.

When $V_C$ becomes a low level, both $P_3$ and $N_3$ becomes ON, so the base potential of $T_1$ and $T_2$ become high and low respectively. Therefore, $T_1$ and $T_2$ are forced to be OFF, so that the impedance looked from a load connected to a signal output terminal $TM_O$ is kept high. When $V_C$ is in a low level and $V_{IN}$ is in a low level, both $P_1$ and $P_2$ are ON, so a current flows from $V_{DD}$ to $V_{SS}$ through $P_2$, $R_2$, and $N_3$. However, the current is suppressed by $R_2$ so little that there is no necessary to consider the power dissipation in the gate circuit.

On the other hand, when $V_C$ is in a low level and $V_{IN}$ is in a high level, a current flows from $V_{DD}$ to $V_{SS}$ through $P_3$, $R_1$, and $N_1$, however the current also can be sufficiently suppressed by $R_1$. Thus, $R_1$ and $R_2$ work in the gate circuit not only to avoid making $T_1$ and $T_2$ ON but also to suppress the current dissipation when the gate circuit is applied as a 3-state circuit which is operating in a high impedance state.

Fig. 6 shows another embodiment when the complementary Bi-MOS gate circuit of the present invention is applied as the 3-state circuit. In Fig. 6, the parts having the same symbols and numerals to those in Fig. 5 is the same parts of Fig. 5. The application can be made by adding a PMOS transistor $P_4$ between $P_2$ and $R_2$ and an NMOS transistor $N_4$ between $N_1$ and $R_1$ to the 3-state circuit of Fig. 5. The gate of $P_4$ is connected to the gate of $N_3$ and the gate of $N_4$ is connected to $TM_C$. When $V_C$ is in a low level and the 3-state circuit operates in a high impedance state, the current paths having been explained in Fig. 5 can be removed because $P_4$ and $N_4$ become OFF.

## Claims

1. A complementary Bi-MIS gate circuit, comprising
   a first CMIS circuit having a first PMIS transistor ($P_1$) connected to a high potential source ($V_{DD}$), a first NMIS transistor ($N_1$) connected to a low potential source ($V_{SS}$) and a first impedance element ($R_1$) inserted between said first PMIS transistor ($P_1$) and said first NMIS transistor ($N_1$);
   a second CMIS circuit having a second PMIS transistor ($P_2$) connected to said high potential source, a second NMIS transistor ($N_2$) connected to said low potential source, and a second impedance element ($R_2$) inserted between said second PMIS transistor ($P_2$) and said second NMIS transistor ($N_2$);
   a signal input terminal ($TM_I$) operatively connected to the gate terminals of said first and second PMIS and NMIS transistors ($P_1$, $P_2$, $N_1$, $N_2$);
   a load driving invertor having a PNP-type pull-up bipolar transistor ($T_1$) and a NPN-type pull-down bipolar transistor ($T_2$), said pull-up and pull-down bipolar transistors ($T_1$, $T_2$) being connected in series between the high and low potential source ($V_{DD}$, $V_{SS}$);
   the base terminal of said pull-up bipolar transistor ($T_1$) being operatively connected to the connecting point (B) of said first PMIS transistor ($P_1$) and said first impedance element ($R_1$);
   the base terminal of said pull-down bipolar transistor ($T_2$) being operatively connected to the connecting point (C) of said second NMIS transistor ($N_2$) and said second impedance element ($R_2$); and
   a signal output terminal ($TM_O$) operatively connected to the connecting point of said pull-up and pull-down bipolar transistors ($T_1$, $T_2$) to said signal output terminal.

2. The complementary Bi-MIS gate circuit according to claim 1, further comprising
   a third PMIS transistor ($P_3$) connected between said base terminal of said pull-up bipolar transistor ($T_1$) and said high potential source;
   a third NMIS transistor ($N_3$) connected between said base terminal of said pull-down bipolar transistor ($T_2$) and said low potential source;
   means ($TM_C$) for feeding an enable signal to the gate terminal of said third PMIS transistor ($P_3$); and
   means ($TM_C$; I) for feeding the inverted signal of said enable signal to the gate terminal of said third NMIS transistor ($N_3$).

3. The complementary Bi-MIS gate circuit according to claim 2 further comprising
   a fourth PMIS transistor ($P_4$) connected between said second PMIS transistor ($P_2$) and said second impedance element ($R_2$);
   a fourth NMIS transistor ($N_4$) connected between said first NMIS transistor ($N_1$) and said first impedance element ($R_1$);
   means ($TM_C$; I) for feeding said inverted signal of said enable signal to the gate terminal of said fourth PMIS transistor ($P_4$); and
   means ($TM_C$) for feeding said enable signal to the gate terminal of said fourth NMIS transistor ($N_4$).

4. The complementary Bi-MIS gate circuit according to any one of claims 1 to 3, wherein said PMIS transistor comprises a PMOS transistor ($P_1$, $P_2$, $P_3$, $P_4$) and said NMIS transistor comprises a NMOS transistor ($N_1$, $N_2$, $N_3$, $N_4$).

5. The complementary Bi-MIS gate circuit according to any one of claims 1 to 4, wherein said impedance element comprises a resistor (R$_1$, R$_2$).

**Patentansprüche**

1. Komplementäre Bi-MIS Torschaltung, welche umfaßt:

eine erste CMIS Schaltungsanordnung, welche einen mit einer hohen Potentialquelle (V$_{DD}$) verbundenen ersten PMIS-Transistor (P$_1$),

einen mit einer niederen Potentialquelle (V$_{SS}$) verbundenen ersten NMIS-Transistor (N$_1$) und

ein zwischen dem ersten PMIS-Transistor (P$_1$) und dem ersten NMIS-Transistor (N$_1$) eingefügtes erstes Impedanzelement (R$_1$) aufweist;

eine zweite CMIS Schaltungsanordnung, welche

einen mit der hohen Potentialquelle (V$_{DD}$) verbundenen zweiten PMIS-Transistor (P$_2$),

einen mit der niederen Potentialquelle (V$_{SS}$) verbundenen zweiten NMIS-Transistor (N$_2$) und

ein zwischen dem zweiten PMIS-Transistor (P$_2$) und dem zweiten NMIS-Transistor (N$_2$) eingefügtes zweites Impedanzelement (R$_2$) aufweist;

ein funktionsmäßig mit den Gate-Anschlüssen von erstem und zweitem PMIS- und NMIS- Transistor (P$_1$, P$_2$, N$_1$, N$_2$) verbundenen Signaleingangsanschluß (TM$_I$);

einen Lastansteuerungsinverter mit einem pull-up PNP-Bipolartransistor (T$_1$) und einem pull-down NPN-Bipolartransistor, die zwischen der hohen (V$_{DD}$) und der niederen (V$_{SS}$) Potentialquelle in Reihe geschaltet sind,

wobei die Basis des pull-up Bipolartransistors (T$_1$) funktionsmäßig mit dem Verbindungspunkt (B) zwischen dem ersten PMIS-Transistor (P$_1$) und dem ersten Impedanzelement (P$_1$) verbunden ist,

wobei die Basis des pull-down Bipolartransistors (T$_2$) funktionsmäßig mit dem Verbindungspunkt (C) zwischen dem zweiten NMIS-Transistor (N$_2$) und dem zweiten Impedanzelement (R$_2$) verbunden ist, und

einen funktionsmäßig mit dem Verbindungspunkt zwischen dem pull-up und dem pull-down Bipolartransistor (T$_1$, T$_2$) verbundenen Signalausgangsanschluß (TM$_O$).

2. Komplementäre Bi-MIS Torschaltung nach Anspruch 1, welche ferner umfaßt:

einen zwischen die Basis des pull-up Bipolartransistors (T$_1$) und der hohen Potentialquelle geschalteten dritten PMIS-Transistor (P$_3$);

einen zwischen die Basis des pull-down Bipolartransistors (T$_2$) und der niederen Potentialquelle geschalteten dritten NMIS-Transistor (N$_3$);

eine Einrichtung (TM$_C$) zum Zuführen eines Freigabesignales an den Gate-Anschluß des dritten PMIS-Transistors (P$_3$) und

eine Einrichtung (TM$_C$; I) zum Zuführen des invertierten Signales des Freigabesignales an den Gate-Anschluß des dritten NMIS-Transistors (N$_3$).

3. Komplementäre Bi-MIS Torschaltung nach Anspruch 2, welche weiterhin umfaßt:

einen zwischen den zweiten PMIS-Transistor (P$_2$) und das zweite Impedanzelement (R$_2$) geschalteten vierten PMIS-Transistor (P$_4$);

einen zwischen den ersten NMIS-Transistor (N$_1$) und das erste Impedanzelement (R$_1$) geschalteten vierten NMIS-Transistor (N$_4$);

eine Einrichtung (TM$_C$; I) zum Zuführen des invertierten Signales des Freigabesignales an den Gate-Anschluß des vierten PMIS-Transistors (P$_4$) und

eine Einrichtung (TM$_C$) zum Zuführen des Freigabesignales an den Gate-Anschluß des vierten NMIS-Transistors (N$_4$).

4. Komplementäre Ni-MIS Torschaltung nach einem der Ansprüche 1 bis 3, bei der der erste PMIS-Transistor einen PMOS-Transistor (P$_1$, P$_2$, P$_3$, P$_4$) und der NMIS-Transistor einen NMOS-Transistor (N$_1$, N$_2$, N$_3$, N$_4$) aufweist.

5. Komplementäre Bi-MIS Torschaltung nach einem der Ansprüche 1 bis 4, bei der das Impedanzelement einen Widerstand (R$_1$, R$_2$) aufweist.

**Revendications**

1. Un circuit de porte Bi-MIS complémentaire, comprenant:

un premier circuit CMIS comprenant un premier transistor PMIS (P$_1$) connecté à une source de potentiel haut (V$_{DD}$), un premier transistor NMIS (N$_1$) connecté à une source de potentiel bas (V$_{SS}$), et un premier élément à impédance (R$_1$) intercale entre le premier transistor PMIS (P$_1$) et le premier transistor NMIS (N$_1$);

un second circuit CMIS comportant un second transistor PMIS (P$_2$) connecté à la source de potentiel haut, un second transistor NMIS (N$_2$) connecté à la source de potentiel bas, et un second élément à impédance (R$_2$) intercalé entre le second transistor PMIS (P$_2$) et le second transistor NMIS (N$_2$);

une borne d'entrée de signal (TM$_I$) connectée fonctionnellement aux bornes de grille des premier et second transistors PMIS et NMIS (P$_1$, P$_2$, N$_1$, N$_2$);

un inverseur d'attaque de charge comprenant un transistor bipolaire de rappel au potentiel haut, de type PNP (T$_1$), et un transistor bipolaire de rappel au potentiel bas de type NPN (T$_2$), ces transistors bipolaires de rappel au potentiel haut et de rappel au potentiel bas (T$_1$, T$_2$) étant connectés en série entre les sources de potentiels haut et bas (V$_{DD}$, V$_{SS}$);

a borne de base du transistor bipolaire de rappel au potentiel haut (T$_1$) étant connectée fonctionnellement au point de connexion (B) du premier transistor PMIS (P$_1$) et du premier élément à impédance (R$_1$);

la borne de base du transistor bipolaire de rappel au potentiel bas (T$_2$) étant connectée fonctionnellement au point de connexion (C) du second transistor NMIS (N$_2$) et du second élément à impédance (R$_2$), et

une borne de sortie de signal (TM$_O$) connectée fonctionnellement au point de connexion des transistors bipolaires de rappel au potentiel haut et de rappel au potentiel bas (T$_1$, T$_2$).

2. Le circuit de porte Bi-MIS complémentaire selon la revendication 1, comprenant en outre:

un troisième transistor PMIS (P$_3$) connecté entre la borne de base du transistor bipolaire de rappel au potentiel haut (T$_1$) et le source de potentiel haut;

un troisième transistor NMIS (N$_3$) connecté entre la borne de base du transistor bipolaire de rappel au potentiel bas (T$_2$) et la source de potentiel bas;

des moyens (TM$_c$) destinés à appliquer un signal de validation à la borne de grille du troisième transistor PMIS (P$_3$); et

des moyens (TM$_c$; I) destinés à appliquer la forme inversée de ce signal de validation à la borne de grille de troisième transistor NMIS (N$_3$).

3. Le circuit de porte Bi-MIS complémentaire selon la revendication 2, comprenant en outre:

un quatrième transistor PMIS (P$_4$) connecté entre le second transistor PMIS (P$_2$) et le second élément à impédance (R$_2$);

un quatrième transistor NMIS (N$_4$) connecté entre le premier transistor NMIS (N$_1$) et le premier élément à impédance (R$_1$);

des moyens (TM$_c$, I), destinés à appliquer la forme inversée du signal de validation à la borne de grille du quatrième transistor PMIS (P$_4$); et

des moyens (TM$_c$) destinés à appliquer le signal de validation à la borne de grille du quatrième transistor NMIS (N$_4$).

4. Le circuit de porte Bi-MIS complémentaire selon l'une quelconque des revendications 1 à 3, dans lequel le transistor PMIS consiste en un transistor PMOS (P$_1$, P$_2$, P$_3$, P$_4$) et le transistor NMIS consiste en un transistor NMOS (N$_1$, N$_2$, N$_3$, N$_4$).

5. Le circuit de porte Bi-MIS complémentaire selon l'une quelconque des revendications 1 à 4, dans lequel l'élément à impédance consiste en une résistance (R$_1$, R$_2$).

FIG.1

PRIOR ART

FIG. 2A

FIG. 2C

FIG. 2B

FIG. 3A

FIG. 3B

FIG. 3C

## FIG. 4

EP 0 172 350 B1

FIG. 5

FIG. 6

5